# EUROPEAN PATENT APPLICATION

(11) **EP 4 586 292 A1**
(43) Date of publication of application: **16.07.2025**
(21) Application number: 24151024.7
(22) Date of filing: 09.01.2024
(51) Int. Cl.: H01H 1/00, H01H 11/00, H01H 71/04

(54) **CIRCUIT BREAKER VIBRATION DATA UTILIZATION**

(71) Applicant: ABB SCHWEIZ AG, 5400 Baden (CH)
(72) Inventor: GITZEL, Ralf, 68165 Mannheim (DE); BOYACI, Aydin, 76337 Waldbronn (DE); PENNER, Simon, 67574 Osthofen (DE); MIGUNOV, Vadim, 68526 Ladenburg (DE); BOY, Felix, 69120 Heidelberg (DE); LOSS, Theresa, 68167 Mannheim (DE)
(74) Representative: Maiwald GmbH

(57) **Abstract**

The present invention relates to a circuit breaker monitoring system, comprising:
- a vibration sensor (10);
- a processing unit (20); and
- an output unit (30);
wherein the vibration sensor is configured to be mounted to a circuit breaker;
wherein the vibration sensor is configured to acquire temporal vibration data over at least a portion of a closing operation of the circuit breaker, wherein the at least a portion of the closing operation comprises: movement of a moveable contact towards a fixed contact;
wherein the vibration sensor is configured to provide the temporal vibration data to the processing unit;
wherein the processing unit is configured to determine an indication of operational functionality of the circuit breaker, wherein the determination comprising analysis of the temporal vibration data by a machine learning algorithm, and wherein the machine learning algorithm was trained on a plurality of travel curve data of a moveable contact with respect to a fixed contact over at least a portion of a plurality of reference closing operations of at least one reference circuit breaker and was trained on a plurality of temporal vibration data over the at least a portion of the plurality of the reference closing operations of the at least one reference circuit breaker, wherein the at least a portion of the reference closing operations comprised: movement of a moveable contact towards a fixed contact; and
wherein the output unit is configured to output information relating to the indication of operational functionality of the circuit breaker.

## Description

### FIELD OF THE INVENTION

The present invention relates to circuit breaker monitoring systems, circuit breaker monitoring methods, circuit breaker vibrations data generators, circuit breaker vibrations data generation methods, as well as computer program elements.

### BACKGROUND OF THE INVENTION

The operating mechanism of a circuit breaker is one of the main subsystems prone to failure of a switchgear. Most of the mechanical failure modes occurring in the mechanism can be detected by monitoring the travel curve that represents the position of the moving contact. Furthermore, the travel curve may also reveal electrical failure modes like contact ablation.

Currently, the gold standard for condition monitoring and diagnostics of the operating mechanism of a circuit breaker (CB) is to use travel curve measurements. For medium-voltage circuit breakers, the travel curve is measured with position sensors at the main shaft of the operating mechanism or at the push rods connected with the three poles. Alternatively, velocity sensors or even accelerometers can be used to transform the measured sensor signal by integration into a displacement describing the travel curve.

In a laboratory setting where cost and other practical concerns have less impact such setups give the best results and can be used to generate training data for machine learning or threshold-based algorithms.

However, the use of travel curves in larger fleets in the field is not always realistic. Thus, today, travel curve monitoring is rarely applied in switchgears in the field, with the reasons being related to cost, limited space, and issues with sensor lifetime.

There is a need to address these issue.

### SUMMARY OF THE INVENTION

Therefore, it would be advantageous to have an improved technique to enable monitoring of a circuit breaker of a switchgear.

The object of the present invention is solved with the subject matter of the independent claims, wherein further embodiments are incorporated in the dependent claims.

In a first aspect, there is provided a circuit breaker monitoring system, comprising:
- a vibration sensor;
- a processing unit; and
- an output unit.
The vibration sensor is configured to be mounted to a circuit breaker. The vibration sensor is configured to acquire temporal vibration data over at least a portion of a closing operation of the circuit breaker. The at least a portion of the closing operation comprises: movement of a moveable contact towards a fixed contact. The vibration sensor is configured to provide the temporal vibration data to the processing unit. The processing unit is configured to determine an indication of operational functionality of the circuit breaker, the determination comprising analysis of the temporal vibration data by a machine learning algorithm. The machine learning algorithm was trained on a plurality of travel curve data of a moveable contact with respect to a fixed contact over at least a portion of a plurality of reference closing operations of at least one reference circuit breaker and was trained on a plurality of temporal vibration data over the at least a portion of the plurality of the reference closing operations of the at least one reference circuit breaker. The at least a portion of the reference closing operations comprised: movement of a moveable contact towards a fixed contact. The output unit is configured to output information relating to the indication of operational functionality of the circuit breaker.

In an example, the at least a portion of the closing operation of the circuit breaker is the same as the at least a portion of the plurality of the reference closing operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact.

In an example, the at least a portion of the closing operation of the circuit breaker comprises initiation of the closing operation and/or latch release, and the at least a portion of the plurality of the reference closing operations of the at least one reference circuit breaker comprised initiation of the closing operation and/or latch release.

In an example, the at least a portion of the closing operation of the circuit breaker comprises contact touch of the moveable contact with the fixed contact and/or stop of movement of the moveable contact, and the at least a portion of the plurality of the reference closing operations of the at least one reference circuit breaker comprised contact touch of the moveable contact with the fixed contact and/or stop of movement of the moveable contact.

In an example, at least some of the plurality of temporal vibration data over the at least a portion of the plurality of the reference closing operations of the at least one reference circuit breaker was synthetically generated by a circuit breaker vibration data generator.

In an example, at least some of the plurality of travel curve data of a moveable contact with respect to a fixed contact over at least a portion of a plurality of reference closing operations of at least one reference circuit breaker was synthetically generated.

In a second aspect, there is provided a circuit breaker monitoring system, comprising:
- a vibration sensor;
- a processing unit; and
- an output unit.

The vibration sensor is configured to be mounted to a circuit breaker. The vibration sensor is configured to acquire temporal vibration data over at least a portion of an opening operation of the circuit breaker. The at least a portion of the opening operation comprises: movement of a moveable contact away from a fixed contact. The vibration sensor is configured to provide the temporal vibration data to the processing unit. The processing unit is configured to determine an indication of operational functionality of the circuit breaker, the determination comprising analysis of the temporal vibration data by a machine learning algorithm. The machine learning algorithm was trained on a plurality of travel curve data of a moveable contact with respect to a fixed contact over at least a portion of a plurality of reference opening operations of at least one reference circuit breaker and was trained on a plurality of temporal vibration data over at least a portion of the plurality of the reference opening operations of the at least one reference circuit breaker. The at least a portion of the reference opening operations comprised: movement of a moveable contact away from a fixed contact. The output unit is configured to output information relating to the indication of operational functionality of the circuit breaker.

In an example, the at least a portion of the opening operation of the circuit breaker is the same as the at least a portion of the plurality of the reference opening operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact.

In an example, the at least a portion of the opening operation of the circuit breaker comprises initiation of the opening operation and/or latch release, and the at least a portion of the plurality of the reference opening operations of the at least one reference circuit breaker comprised initiation of the opening operation and/or latch release.

In an example, the at least a portion of the opening operation of the circuit breaker comprises separation of the moveable contact from the fixed contact and/or stop of movement of the moveable contact, and the at least a portion of the plurality of the reference opening operations of the at least one reference circuit breaker comprised separation of the moveable contact from the fixed contact and/or stop of movement of the moveable contact.

In an example, at least some of the plurality of temporal vibration data over the at least a portion of the plurality of the reference opening operations of the at least one reference circuit breaker was synthetically generated by a circuit breaker vibration data generator.

In an example, at least some of the plurality of travel curve data of a moveable contact with respect to a fixed contact over at least a portion of a plurality of reference opening operations of at least one reference circuit breaker was synthetically generated.

In a third aspect, there is provided a circuit breaker monitoring method, comprising:
- acquiring, by a vibration sensor mounted to a circuit breaker, temporal vibration data over at least a portion of a closing operation of the circuit breaker, wherein the at least a portion of the closing operation comprises: movement of a moveable contact towards a fixed contact;
- providing, by the vibration sensor, the temporal vibration data to a processing unit;
- determining, by the processing unit, an indication of operational functionality of the circuit breaker, wherein the determining comprising analysing the temporal vibration data by a machine learning algorithm, and wherein the machine learning algorithm was trained on a plurality of travel curve data of a moveable contact with respect to a fixed contact over at least a portion of a plurality of reference closing operations of at least one reference circuit breaker and was trained on a plurality of temporal vibration data over the at least a portion of the plurality of the reference closing operations of the at least one reference circuit breaker, wherein the at least a portion of the reference closing operations comprised: movement of a moveable contact towards a fixed contact; and
- outputting, by an output unit, information relating to the indication of operational functionality of the circuit breaker.

In an example, the at least a portion of the closing operation of the circuit breaker is the same as the at least a portion of the plurality of the reference closing operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact.

In an example, the at least a portion of the closing operation of the circuit breaker comprises initiation of the closing operation and/or latch release, and wherein the at least a portion of the plurality of the reference closing operations of the at least one reference circuit breaker comprised initiation of the closing operation and/or latch release.

In an example, the at least a portion of the closing operation of the circuit breaker comprises contact touch of the moveable contact with the fixed contact and/or stop of movement of the moveable contact, and wherein the at least a portion of the plurality of the reference closing operations of the at least one reference circuit breaker comprised contact touch of the moveable contact with the fixed contact and/or stop of movement of the moveable contact.

In an example, at least some of the plurality of temporal vibration data over the at least a portion of the plurality of the reference closing operations of the at least one reference circuit breaker was synthetically generated by a circuit breaker vibration data generator.

In an example, at least some of the plurality of travel curve data of a moveable contact with respect to a fixed contact over at least a portion of a plurality of reference closing operations of at least one reference circuit breaker was synthetically generated.

In a fourth aspect, there is provided a circuit breaker monitoring method, comprising:
- acquiring, by a vibration sensor mounted to a circuit breaker, temporal vibration data over at least a portion of an opening operation of the circuit breaker, wherein the at least a portion of the opening operation comprises: movement of a moveable contact away from a fixed contact;
- providing, by the vibration sensor, the temporal vibration data to a processing unit;
- determining, by the processing unit, an indication of operational functionality of the circuit breaker, wherein the determining comprising analysing the temporal vibration data by a machine learning algorithm, and wherein the machine learning algorithm was trained on a plurality of travel curve data of a moveable contact with respect to a fixed contact over at least a portion of a plurality of reference opening operations of at least one reference circuit breaker and was trained on a plurality of temporal vibration data over at least a portion of the plurality of the reference opening operations of the at least one reference circuit breaker, wherein the at least a portion of the reference opening operations comprised: movement of a moveable contact away from a fixed contact; and
- wherein the output unit is configured to output information relating to the indication of operational functionality of the circuit breaker.

In an example, the at least a portion of the opening operation of the circuit breaker is the same as the at least a portion of the plurality of the reference opening operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact.

In an example, the at least a portion of the opening operation of the circuit breaker comprises initiation of the opening operation and/or latch release, and wherein the at least a portion of the plurality of the reference opening operations of the at least one reference circuit breaker comprised initiation of the opening operation and/or latch release.

In an example, the at least a portion of the opening operation of the circuit breaker comprises separation of the moveable contact from the fixed contact and/or stop of movement of the moveable contact, and wherein the at least a portion of the plurality of the reference opening operations of the at least one reference circuit breaker comprised separation of the moveable contact from the fixed contact and/or stop of movement of the moveable contact.

In an example, at least some of the plurality of temporal vibration data over the at least a portion of the plurality of the reference opening operations of the at least one reference circuit breaker was synthetically generated by a circuit breaker vibration data generator.

In an example, at least some of the plurality of travel curve data of a moveable contact with respect to a fixed contact over at least a portion of a plurality of reference opening operations of at least one reference circuit breaker was synthetically generated.

In a fifth aspect, there is provided a circuit breaker vibration data generator, comprising:
- an input unit;
- a processing unit;
- an output unit.
The input unit is configured to provide the processing unit with a plurality of travel curve data of a moveable contact with respect to a fixed contact over at least a portion of a plurality of reference closing operations of at least one reference circuit breaker and a plurality of temporal vibration data over the at least a portion of the plurality of the reference closing operations of the at least one reference circuit breaker. The at least a portion of the reference closing operations comprised: movement of a moveable contact towards a fixed contact. The plurality of temporal vibration data was acquired by at least one vibration sensor mounted to the at least one reference circuit breaker. The processing unit is configured to train a sequence to sequence model comprising utilization of the plurality of travel curve data of the moveable contact with respect to the fixed contact over the at least a portion of the plurality of reference closing operations of the at least one reference circuit breaker and the plurality of temporal vibration data over the at least a portion of the plurality of the reference closing operations of the at least one reference circuit breaker. The input unit is configured to provide the processing unit with exemplar travel curve data of a moveable contact with respect to a fixed contact over at least a portion of a closing operation of an exemplar circuit breaker, and the at least a portion of the closing operation comprised: movement of a moveable contact towards a fixed contact. The processing unit is configured to generate exemplar temporal vibration data over the at least a portion of the closing operation of the exemplar circuit breaker, the generation comprising analysis of the exemplar travel curve data of the moveable contact with respect to the fixed contact over the at least a portion of the closing operation of the exemplar circuit breaker by the trained sequence to sequence model. The output unit is configured to output the exemplar temporal vibration data over the at least a portion of the closing operation of the exemplar circuit breaker.

In an example, the at least a portion of the closing operation of the exemplar circuit breaker is the same as the at least a portion of the plurality of the reference closing operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact, and the travel curve data of the moveable contact with respect to the fixed contact of the closing operation of the exemplar circuit breaker comprises displacement data as a function of time of the moveable contact with respect to the fixed contact
In an example, the at least a portion of the closing operation of the exemplar circuit breaker comprised initiation of the closing operation and/or latch release, and wherein the at least a portion of the plurality of the reference closing operations of the at least one reference circuit breaker comprised initiation of the closing operation and/or latch release.

In an example, the at least a portion of the closing operation of the exemplar circuit breaker comprised contact touch of the moveable contact with the fixed contact and/or stop of movement of the moveable contact, and wherein the at least a portion of the plurality of the reference closing operations of the at least one reference circuit breaker comprised contact touch of the moveable contact with the fixed contact and/or stop of movement of the moveable contact.

In an example, at least some of the plurality of travel curve data of a moveable contact with respect to a fixed contact over at least a portion of a plurality of reference closing operations of at least one reference circuit breaker was synthetically generated.

In a sixth aspect, there is provided a circuit breaker vibration data generator, comprising:
- an input unit;
- a processing unit;
- an output unit.
The input unit is configured to provide the processing unit with a plurality of travel curve data of a moveable contact with respect to a fixed contact over at least a portion of a plurality of reference opening operations of at least one reference circuit breaker and a plurality of temporal vibration data over the at least a portion of the plurality of the reference opening operations of the at least one reference circuit breaker. The at least a portion of the reference opening operations comprised: movement of a moveable contact away from a fixed contact. The plurality of temporal vibration data was acquired by at least one vibration sensor mounted to the at least one reference circuit breaker. The processing unit is configured to train a sequence to sequence model comprising utilization of the plurality of travel curve data of the moveable contact with respect to the fixed contact over the at least a portion of the plurality of reference opening operations of the at least one reference circuit breaker and the plurality of temporal vibration data over the at least a portion of the plurality of the reference opening operations of the at least one reference circuit breaker. The input unit is configured to provide the processing unit with exemplar travel curve data of a moveable contact with respect to a fixed contact over at least a portion of an opening operation of an exemplar circuit breaker, and the at least a portion of the opening operation comprised: movement of a moveable contact away from a fixed contact. The processing unit is configured to generate exemplar temporal vibration data over the at least a portion of the opening operation of the exemplar circuit breaker, the generation comprising analysis of the exemplar travel curve data of the moveable contact with respect to the fixed contact over the at least a portion of the opening operation of the exemplar circuit breaker by the trained sequence to sequence model. The output unit is configured to output the exemplar temporal vibration data over the at least a portion of the opening operation of the exemplar circuit breaker.

In an example, the at least a portion of the opening operation of the exemplar circuit breaker is the same as the at least a portion of the plurality of the reference opening operations of the at least one reference circuit breaker.

In an example, the plurality of travel curve data of the moveable contact with respect to the fixed contact of the plurality of reference opening operations of the at least one reference circuit breaker comprises displacement data as a function of time of the moveable contact with respect to the fixed contact, and the travel curve data of the moveable contact with respect to the fixed contact of the opening operation of the exemplar circuit breaker comprises displacement data as a function of time of the moveable contact with respect to the fixed contact

In an example, the at least a portion of the opening operation of the exemplar circuit breaker comprised initiation of the opening operation and/or latch release, and wherein the at least a portion of the plurality of the reference opening operations of the at least one reference circuit breaker comprised initiation of the opening operation and/or latch release.

In an example, the at least a portion of the opening operation of the exemplar circuit breaker comprised separation of the moveable contact from the fixed contact and/or stop of movement of the moveable contact, and wherein the at least a portion of the plurality of the reference opening operations of the at least one reference circuit breaker comprised separation of the moveable contact from the fixed contact and/or stop of movement of the moveable contact.

In an example, at least some of the plurality of travel curve data of a moveable contact with respect to a fixed contact over at least a portion of a plurality of reference opening operations of at least one reference circuit breaker was synthetically generated.

In a seventh aspect, there is provided a circuit breaker vibration data generation method, comprising:
- providing, by an input unit, a processing unit with a plurality of travel curve data of a moveable contact with respect to a fixed contact over at least a portion of a plurality of reference closing operations of at least one reference circuit breaker and a plurality of temporal vibration data over the at least a portion of the plurality of the reference closing operations of the at least one reference circuit breaker, wherein the at least a portion of the reference closing operations comprised: movement of a moveable contact towards a fixed contact, and wherein the plurality of temporal vibration data was acquired by at least one vibration sensor mounted to the at least one reference circuit breaker;
- training, by the processing unit, a sequence to sequence model comprising utilizing the plurality of travel curve data of the moveable contact with respect to the fixed contact over the at least a portion of the plurality of reference closing operations of the at least one reference circuit breaker and the plurality of temporal vibration data over the at least a portion of the plurality of the reference closing operations of the at least one reference circuit breaker;
- providing, by the input unit, the processing unit with exemplar travel curve data of a moveable contact with respect to a fixed contact over at least a portion of a closing operation of an exemplar circuit breaker, wherein the at least a portion of the closing operation comprised: movement of a moveable contact towards a fixed contact;
- generating, by the processing unit, exemplar temporal vibration data over the at least a portion of the closing operation of the exemplar circuit breaker, the generating comprising analyzing the exemplar travel curve data of the moveable contact with respect to the fixed contact over the at least a portion of the closing operation of the exemplar circuit breaker by the trained sequence to sequence model; and
- outputting, by an output unit, the exemplar temporal vibration data over the at least a portion of the closing operation of the exemplar circuit breaker.

In an example, the at least a portion of the closing operation of the exemplar circuit breaker is the same as the at least a portion of the plurality of the reference closing operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact, and the travel curve data of the moveable contact with respect to the fixed contact of the closing operation of the exemplar circuit breaker comprises displacement data as a function of time of the moveable contact with respect to the fixed contact

In an example, the at least a portion of the closing operation of the exemplar circuit breaker comprised initiation of the closing operation and/or latch release, and wherein the at least a portion of the plurality of the reference closing operations of the at least one reference circuit breaker comprised initiation of the closing operation and/or latch release.

In an example, the at least a portion of the closing operation of the exemplar circuit breaker comprised contact touch of the moveable contact with the fixed contact and/or stop of movement of the moveable contact, and wherein the at least a portion of the plurality of the reference closing operations of the at least one reference circuit breaker comprised contact touch of the moveable contact with the fixed contact and/or stop of movement of the moveable contact.

In an example, at least some of the plurality of travel curve data of a moveable contact with respect to a fixed contact over at least a portion of a plurality of reference closing operations of at least one reference circuit breaker was synthetically generated.

In an eighth aspect, there is provided a circuit breaker vibration data generation method, comprising:
- providing, by an input unit, a processing unit with a plurality of travel curve data of a moveable contact with respect to a fixed contact over at least a portion of a plurality of reference opening operations of at least one reference circuit breaker and a plurality of temporal vibration data over the at least a portion of the plurality of the reference opening operations of the at least one reference circuit breaker, wherein the at least a portion of the reference opening operations comprised: movement of a moveable contact away from a fixed contact, and wherein the plurality of temporal vibration data was acquired by at least one vibration sensor mounted to the at least one reference circuit breaker;
- training, by the processing unit, a sequence to sequence model comprising utilizing the plurality of travel curve data of the moveable contact with respect to the fixed contact over the at least a portion of the plurality of reference opening operations of the at least one reference circuit breaker and the plurality of temporal vibration data over the at least a portion of the plurality of the reference opening operations of the at least one reference circuit breaker;
- providing, by the input unit, the processing unit with exemplar travel curve data of a moveable contact with respect to a fixed contact over at least a portion of an opening operation of an exemplar circuit breaker, wherein the at least a portion of the opening operation comprised: movement of a moveable contact away from a fixed contact;

- generating, by the processing unit, exemplar temporal vibration data over the at least a portion of the opening operation of the exemplar circuit breaker, the generating comprising analysis of the exemplar travel curve data of the moveable contact with respect to the fixed contact over the at least a portion of the opening operation of the exemplar circuit breaker by the trained sequence to sequence model; and
- outputting, by an output unit, the exemplar temporal vibration data over the at least a portion of the opening operation of the exemplar circuit breaker.

In an example, the at least a portion of the opening operation of the exemplar circuit breaker is the same as the at least a portion of the plurality of the reference opening operations of the at least one reference circuit breaker.

In an example, the plurality of travel curve data of the moveable contact with respect to the fixed contact of the plurality of reference opening operations of the at least one reference circuit breaker comprises displacement data as a function of time of the moveable contact with respect to the fixed contact, and the travel curve data of the moveable contact with respect to the fixed contact of the opening operation of the exemplar circuit breaker comprises displacement data as a function of time of the moveable contact with respect to the fixed contact

In an example, the at least a portion of the opening operation of the exemplar circuit breaker comprised initiation of the opening operation and/or latch release, and wherein the at least a portion of the plurality of the reference opening operations of the at least one reference circuit breaker comprised initiation of the opening operation and/or latch release.

In an example, the at least a portion of the opening operation of the exemplar circuit breaker comprised separation of the moveable contact from the fixed contact and/or stop of movement of the moveable contact, and wherein the at least a portion of the plurality of the reference opening operations of the at least one reference circuit breaker comprised separation of the moveable contact from the fixed contact and/or stop of movement of the moveable contact.

In an example, at least some of the plurality of travel curve data of a moveable contact with respect to a fixed contact over at least a portion of a plurality of reference opening operations of at least one reference circuit breaker was synthetically generated.

In a ninth aspect, there is provided a computer program element for controlling a system which when executed by a processor is configured to carry out the method according to the third aspect.

In an example, there is provided a computer readable medium having stored the computer element of the ninth aspect.

In a tenth aspect, there is provided a computer program element for controlling a system which when executed by a processor is configured to carry out the method according to the fourth aspect.

In an example, there is provided a computer readable medium having stored the computer element of the tenth aspect.

In an eleventh aspect, there is provided a computer program element for controlling a system which when executed by a processor is configured to carry out the method according to the seventh aspect.

In an example, there is provided a computer readable medium having stored the computer element of the eleventh aspect.

In a twelfth aspect, there is provided a computer program element for controlling a system which when executed by a processor is configured to carry out the method according to the eighth aspect.

In an example, there is provided a computer readable medium having stored the computer element of the twelfth aspect.

The computer program elements can for example be a software program but can also be a FPGA, a PLD or any other appropriate digital means.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows an exemplar circuit breaker monitoring system;
Fig. 2 shows an exemplar circuit breaker vibration data generator;
Fig. 3 shows a detailed example of the training and operation of an exemplar circuit breaker vibration data generator;
Fig. 4 shows a detailed example of the operation of an exemplar circuit breaker vibration data generator; and
Fig. 5 shows a representation of the utilization of generated data.

### DETAILED DESCRIPTION OF EMBODIMENTS

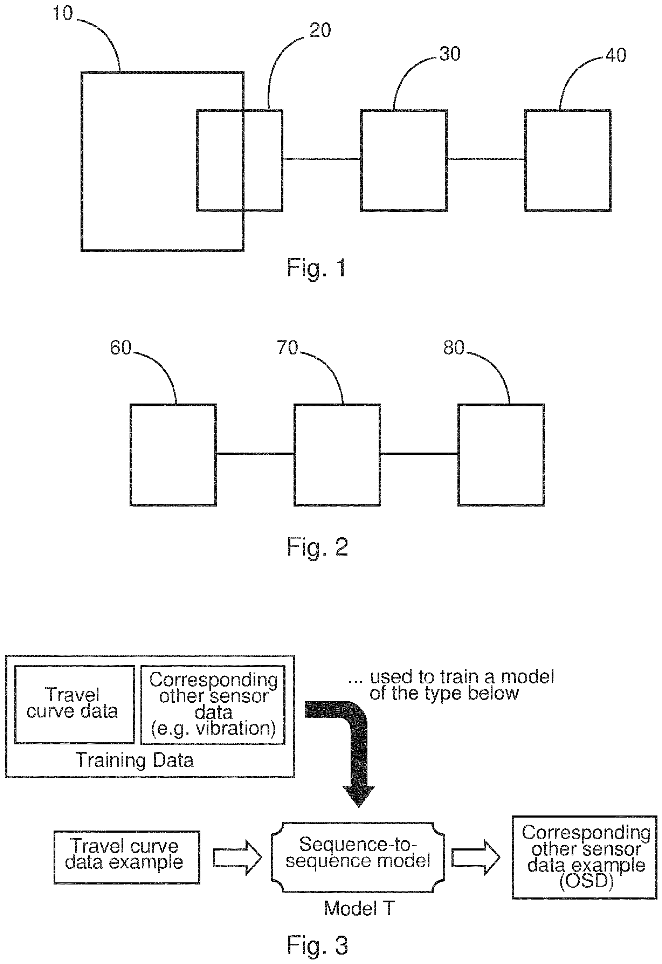

Fig. 1 shows an example circuit breaker monitoring system, comprising:
- a vibration sensor 10;
- a processing unit 20; and
- an output unit 30.
The vibration sensor is configured to be mounted to a circuit breaker. The vibration sensor is configured to acquire temporal vibration data over at least a portion of a closing operation of the circuit breaker. The at least a portion of the closing operation comprises: movement of a moveable contact towards a fixed contact. The vibration sensor is configured to provide the temporal vibration data to the processing unit. The processing unit is configured to determine an indication of operational functionality of the circuit breaker, the determination comprising analysis of the temporal vibration data by a machine learning algorithm. The machine learning algorithm was trained on a plurality of travel curve data of a moveable contact with respect to a fixed contact over at least a portion of a plurality of reference closing operations of at least one reference circuit breaker and was trained on a plurality of temporal vibration data over the at least a portion of the plurality of the reference closing operations of the at least one reference circuit breaker. The at least a portion of the reference closing operations comprised: movement of a moveable contact towards a fixed contact. The output unit is configured to output information relating to the indication of operational functionality of the circuit breaker.

In an example, the at least a portion of the closing operation of the circuit breaker is the same as the at least a portion of the plurality of the reference closing operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact.

In an example, the at least a portion of the closing operation of the circuit breaker comprises initiation of the closing operation and/or latch release, and the at least a portion of the plurality of the reference closing operations of the at least one reference circuit breaker comprised initiation of the closing operation and/or latch release.

In an example, the at least a portion of the closing operation of the circuit breaker comprises contact touch of the moveable contact with the fixed contact and/or stop of movement of the moveable contact, and the at least a portion of the plurality of the reference closing operations of the at least one reference circuit breaker comprised contact touch of the moveable contact with the fixed contact and/or stop of movement of the moveable contact.

In an example, at least some of the plurality of temporal vibration data over the at least a portion of the plurality of the reference closing operations of the at least one reference circuit breaker was synthetically generated by a circuit breaker vibration data generator.

In an example, at least some of the plurality of travel curve data of a moveable contact with respect to a fixed contact over at least a portion of a plurality of reference closing operations of at least one reference circuit breaker was synthetically generated.

The description above relates the monitoring of a closing operation of the circuit breaker. However, Fig. 1 also relates to another circuit breaker monitoring system, comprising:
- a vibration sensor 10;
- a processing unit 20; and
- an output unit 30.
The vibration sensor is configured to be mounted to a circuit breaker. The vibration sensor is configured to acquire temporal vibration data over at least a portion of an opening operation of the circuit breaker. The at least a portion of the opening operation comprises: movement of a moveable contact away from a fixed contact. The vibration sensor is configured to provide the temporal vibration data to the processing unit. The processing unit is configured to determine an indication of operational functionality of the circuit breaker, the determination comprising analysis of the temporal vibration data by a machine learning algorithm. The machine learning algorithm was trained on a plurality of travel curve data of a moveable contact with respect to a fixed contact over at least a portion of a plurality of reference opening operations of at least one reference circuit breaker and was trained on a plurality of temporal vibration data over at least a portion of the plurality of the reference opening operations of the at least one reference circuit breaker. The at least a portion of the reference opening operations comprised: movement of a moveable contact away from a fixed contact. The output unit is configured to output information relating to the indication of operational functionality of the circuit breaker.

In an example, the at least a portion of the opening operation of the circuit breaker is the same as the at least a portion of the plurality of the reference opening operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact.

In an example, the at least a portion of the opening operation of the circuit breaker comprises initiation of the opening operation and/or latch release, and the at least a portion of the plurality of the reference opening operations of the at least one reference circuit breaker comprised initiation of the opening operation and/or latch release.

In an example, the at least a portion of the opening operation of the circuit breaker comprises separation of the moveable contact from the fixed contact and/or stop of movement of the moveable contact, and the at least a portion of the plurality of the reference opening operations of the at least one reference circuit breaker comprised separation of the moveable contact from the fixed contact and/or stop of movement of the moveable contact.

In an example, at least some of the plurality of temporal vibration data over the at least a portion of the plurality of the reference opening operations of the at least one reference circuit breaker was synthetically generated by a circuit breaker vibration data generator.

In an example, at least some of the plurality of travel curve data of a moveable contact with respect to a fixed contact over at least a portion of a plurality of reference opening operations of at least one reference circuit breaker was synthetically generated.

An associated circuit breaker monitoring method relating to the closing operation, comprises:
- acquiring, by a vibration sensor mounted to a circuit breaker, temporal vibration data over at least a portion of a closing operation of the circuit breaker, wherein the at least a portion of the closing operation comprises: movement of a moveable contact towards a fixed contact;
- providing, by the vibration sensor, the temporal vibration data to a processing unit;
- determining, by the processing unit, an indication of operational functionality of the circuit breaker, wherein the determining comprising analysing the temporal vibration data by a machine learning algorithm, and wherein the machine learning algorithm was trained on a plurality of travel curve data of a moveable contact with respect to a fixed contact over at least a portion of a plurality of reference closing operations of at least one reference circuit breaker and was trained on a plurality of temporal vibration data over the at least a portion of the plurality of the reference closing operations of the at least one reference circuit breaker, wherein the at least a portion of the reference closing operations comprised: movement of a moveable contact towards a fixed contact; and
- outputting, by an output unit, information relating to the indication of operational functionality of the circuit breaker.

In an example, the at least a portion of the closing operation of the circuit breaker is the same as the at least a portion of the plurality of the reference closing operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact.

In an example, the at least a portion of the closing operation of the circuit breaker comprises initiation of the closing operation and/or latch release, and wherein the at least a portion of the plurality of the reference closing operations of the at least one reference circuit breaker comprised initiation of the closing operation and/or latch release.

In an example, the at least a portion of the closing operation of the circuit breaker comprises contact touch of the moveable contact with the fixed contact and/or stop of movement of the moveable contact, and wherein the at least a portion of the plurality of the reference closing operations of the at least one reference circuit breaker comprised contact touch of the moveable contact with the fixed contact and/or stop of movement of the moveable contact.

In an example, at least some of the plurality of temporal vibration data over the at least a portion of the plurality of the reference closing operations of the at least one reference circuit breaker was synthetically generated by a circuit breaker vibration data generator.

In an example, at least some of the plurality of travel curve data of a moveable contact with respect to a fixed contact over at least a portion of a plurality of reference closing operations of at least one reference circuit breaker was synthetically generated.

An associated circuit breaker monitoring method relating to the opening operation, comprises:
- acquiring, by a vibration sensor mounted to a circuit breaker, temporal vibration data over at least a portion of an opening operation of the circuit breaker, wherein the at least a portion of the opening operation comprises: movement of a moveable contact away from a fixed contact;
- providing, by the vibration sensor, the temporal vibration data to a processing unit;
- determining, by the processing unit, an indication of operational functionality of the circuit breaker, wherein the determining comprising analysing the temporal vibration data by a machine learning algorithm, and wherein the machine learning algorithm was trained on a plurality of travel curve data of a moveable contact with respect to a fixed contact over at least a portion of a plurality of reference opening operations of at least one reference circuit breaker and was trained on a plurality of temporal vibration data over at least a portion of the plurality of the reference opening operations of the at least one reference circuit breaker, wherein the at least a portion of the reference opening operations comprised: movement of a moveable contact away from a fixed contact; and
- wherein the output unit is configured to output information relating to the indication of operational functionality of the circuit breaker.

In an example, the at least a portion of the opening operation of the circuit breaker is the same as the at least a portion of the plurality of the reference opening operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact.

In an example, the at least a portion of the opening operation of the circuit breaker comprises initiation of the opening operation and/or latch release, and wherein the at least a portion of the plurality of the reference opening operations of the at least one reference circuit breaker comprised initiation of the opening operation and/or latch release.

In an example, the at least a portion of the opening operation of the circuit breaker comprises separation of the moveable contact from the fixed contact and/or stop of movement of the moveable contact, and wherein the at least a portion of the plurality of the reference opening operations of the at least one reference circuit breaker comprised separation of the moveable contact from the fixed contact and/or stop of movement of the moveable contact.

In an example, at least some of the plurality of temporal vibration data over the at least a portion of the plurality of the reference opening operations of the at least one reference circuit breaker was synthetically generated by a circuit breaker vibration data generator.

In an example, at least some of the plurality of travel curve data of a moveable contact with respect to a fixed contact over at least a portion of a plurality of reference opening operations of at least one reference circuit breaker was synthetically generated.

Fig. 2 shows an example of a circuit breaker vibration data generator, comprising:
- an input unit 60;
- a processing unit 70;
- an output unit 80.
The input unit is configured to provide the processing unit with a plurality of travel curve data of a moveable contact with respect to a fixed contact over at least a portion of a plurality of reference closing operations of at least one reference circuit breaker and a plurality of temporal vibration data over the at least a portion of the plurality of the reference closing operations of the at least one reference circuit breaker. The at least a portion of the reference closing operations comprised: movement of a moveable contact towards a fixed contact. The plurality of temporal vibration data was acquired by at least one vibration sensor mounted to the at least one reference circuit breaker. The processing unit is configured to train a sequence to sequence model comprising utilization of the plurality of travel curve data of the moveable contact with respect to the fixed contact over the at least a portion of the plurality of reference closing operations of the at least one reference circuit breaker and the plurality of temporal vibration data over the at least a portion of the plurality of the reference closing operations of the at least one reference circuit breaker. The input unit is configured to provide the processing unit with exemplar travel curve data of a moveable contact with respect to a fixed contact over at least a portion of a closing operation of an exemplar circuit breaker, and the at least a portion of the closing operation comprised: movement of a moveable contact towards a fixed contact. The processing unit is configured to generate exemplar temporal vibration data over the at least a portion of the closing operation of the exemplar circuit breaker, the generation comprising analysis of the exemplar travel curve data of the moveable contact with respect to the fixed contact over the at least a portion of the closing operation of the exemplar circuit breaker by the trained sequence to sequence model. The output unit is configured to output the exemplar temporal vibration data over the at least a portion of the closing operation of the exemplar circuit breaker.

In an example, the at least a portion of the closing operation of the exemplar circuit breaker is the same as the at least a portion of the plurality of the reference closing operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact, and the travel curve data of the moveable contact with respect to the fixed contact of the closing operation of the exemplar circuit breaker comprises displacement data as a function of time of the moveable contact with respect to the fixed contact

In an example, the at least a portion of the closing operation of the exemplar circuit breaker comprised initiation of the closing operation and/or latch release, and wherein the at least a portion of the plurality of the reference closing operations of the at least one reference circuit breaker comprised initiation of the closing operation and/or latch release.

In an example, the at least a portion of the closing operation of the exemplar circuit breaker comprised contact touch of the moveable contact with the fixed contact and/or stop of movement of the moveable contact, and wherein the at least a portion of the plurality of the reference closing operations of the at least one reference circuit breaker comprised contact touch of the moveable contact with the fixed contact and/or stop of movement of the moveable contact.

In an example, at least some of the plurality of travel curve data of a moveable contact with respect to a fixed contact over at least a portion of a plurality of reference closing operations of at least one reference circuit breaker was synthetically generated.

The description above relates the generation of data for a closing operation of the circuit breaker. However, Fig. 2 also relates to another circuit breaker vibration data generator, comprising:
- an input unit 60;
- a processing unit 70;
- an output unit 80.
The input unit is configured to provide the processing unit with a plurality of travel curve data of a moveable contact with respect to a fixed contact over at least a portion of a plurality of reference opening operations of at least one reference circuit breaker and a plurality of temporal vibration data over the at least a portion of the plurality of the reference opening operations of the at least one reference circuit breaker. The at least a portion of the reference opening operations comprised: movement of a moveable contact away from a fixed contact. The plurality of temporal vibration data was acquired by at least one vibration sensor mounted to the at least one reference circuit breaker. The processing unit is configured to train a sequence to sequence model comprising utilization of the plurality of travel curve data of the moveable contact with respect to the fixed contact over the at least a portion of the plurality of reference opening operations of the at least one reference circuit breaker and the plurality of temporal vibration data over the at least a portion of the plurality of the reference opening operations of the at least one reference circuit breaker. The input unit is configured to provide the processing unit with exemplar travel curve data of a moveable contact with respect to a fixed contact over at least a portion of an opening operation of an exemplar circuit breaker, and the at least a portion of the opening operation comprised: movement of a moveable contact away from a fixed contact. The processing unit is configured to generate exemplar temporal vibration data over the at least a portion of the opening operation of the exemplar circuit breaker, the generation comprising analysis of the exemplar travel curve data of the moveable contact with respect to the fixed contact over the at least a portion of the opening operation of the exemplar circuit breaker by the trained sequence to sequence model. The output unit is configured to output the exemplar temporal vibration data over the at least a portion of the opening operation of the exemplar circuit breaker.

In an example, the at least a portion of the opening operation of the exemplar circuit breaker is the same as the at least a portion of the plurality of the reference opening operations of the at least one reference circuit breaker.

In an example, the plurality of travel curve data of the moveable contact with respect to the fixed contact of the plurality of reference opening operations of the at least one reference circuit breaker comprises displacement data as a function of time of the moveable contact with respect to the fixed contact, and the travel curve data of the moveable contact with respect to the fixed contact of the opening operation of the exemplar circuit breaker comprises displacement data as a function of time of the moveable contact with respect to the fixed contact

In an example, the at least a portion of the opening operation of the exemplar circuit breaker comprised initiation of the opening operation and/or latch release, and wherein the at least a portion of the plurality of the reference opening operations of the at least one reference circuit breaker comprised initiation of the opening operation and/or latch release.

In an example, the at least a portion of the opening operation of the exemplar circuit breaker comprised separation of the moveable contact from the fixed contact and/or stop of movement of the moveable contact, and wherein the at least a portion of the plurality of the reference opening operations of the at least one reference circuit breaker comprised separation of the moveable contact from the fixed contact and/or stop of movement of the moveable contact.

In an example, at least some of the plurality of travel curve data of a moveable contact with respect to a fixed contact over at least a portion of a plurality of reference opening operations of at least one reference circuit breaker was synthetically generated.

An associated method for circuit breaker vibration data generation, comprises:
- providing, by an input unit, a processing unit with a plurality of travel curve data of a moveable contact with respect to a fixed contact over at least a portion of a plurality of reference closing operations of at least one reference circuit breaker and a plurality of temporal vibration data over the at least a portion of the plurality of the reference closing operations of the at least one reference circuit breaker, wherein the at least a portion of the reference closing operations comprised: movement of a moveable contact towards a fixed contact, and wherein the plurality of temporal vibration data was acquired by at least one vibration sensor mounted to the at least one reference circuit breaker;
- training, by the processing unit, a sequence to sequence model comprising utilizing the plurality of travel curve data of the moveable contact with respect to the fixed contact over the at least a portion of the plurality of reference closing operations of the at least one reference circuit breaker and the plurality of temporal vibration data over the at least a portion of the plurality of the reference closing operations of the at least one reference circuit breaker;
- providing, by the input unit, the processing unit with exemplar travel curve data of a moveable contact with respect to a fixed contact over at least a portion of a closing operation of an exemplar circuit breaker, wherein the at least a portion of the closing operation comprised: movement of a moveable contact towards a fixed contact;
- generating, by the processing unit, exemplar temporal vibration data over the at least a portion of the closing operation of the exemplar circuit breaker, the generating comprising analyzing the exemplar travel curve data of the moveable contact with respect to the fixed contact over the at least a portion of the closing operation of the exemplar circuit breaker by the trained sequence to sequence model; and
- outputting, by an output unit, the exemplar temporal vibration data over the at least a portion of the closing operation of the exemplar circuit breaker.

In an example, the at least a portion of the closing operation of the exemplar circuit breaker is the same as the at least a portion of the plurality of the reference closing operations of the at least one reference circuit breaker.

In an example, the plurality of travel curve data of the moveable contact with respect to the fixed contact of the plurality of reference closing operations of the at least one reference circuit breaker comprises displacement data as a function of time of the moveable contact with respect to the fixed contact, and the travel curve data of the moveable contact with respect to the fixed contact of the closing operation of the exemplar circuit breaker comprises displacement data as a function of time of the moveable contact with respect to the fixed contact

In an example, the at least a portion of the closing operation of the exemplar circuit breaker comprised initiation of the closing operation and/or latch release, and wherein the at least a portion of the plurality of the reference closing operations of the at least one reference circuit breaker comprised initiation of the closing operation and/or latch release.

In an example, the at least a portion of the closing operation of the exemplar circuit breaker comprised contact touch of the moveable contact with the fixed contact and/or stop of movement of the moveable contact, and wherein the at least a portion of the plurality of the reference closing operations of the at least one reference circuit breaker comprised contact touch of the moveable contact with the fixed contact and/or stop of movement of the moveable contact.

In an example, at least some of the plurality of travel curve data of a moveable contact with respect to a fixed contact over at least a portion of a plurality of reference closing operations of at least one reference circuit breaker was synthetically generated.

An associated method for circuit breaker vibration data generation, comprises:
- providing, by an input unit, a processing unit with a plurality of travel curve data of a moveable contact with respect to a fixed contact over at least a portion of a plurality of reference opening operations of at least one reference circuit breaker and a plurality of temporal vibration data over the at least a portion of the plurality of the reference opening operations of the at least one reference circuit breaker, wherein the at least a portion of the reference opening operations comprised: movement of a moveable contact away from a fixed contact, and wherein the plurality of temporal vibration data was acquired by at least one vibration sensor mounted to the at least one reference circuit breaker;
- training, by the processing unit, a sequence to sequence model comprising utilizing the plurality of travel curve data of the moveable contact with respect to the fixed contact over the at least a portion of the plurality of reference opening operations of the at least one reference circuit breaker and the plurality of temporal vibration data over the at least a portion of the plurality of the reference opening operations of the at least one reference circuit breaker;
- providing, by the input unit, the processing unit with exemplar travel curve data of a moveable contact with respect to a fixed contact over at least a portion of an opening operation of an exemplar circuit breaker, wherein the at least a portion of the opening operation comprised: movement of a moveable contact away from a fixed contact;
- generating, by the processing unit, exemplar temporal vibration data over the at least a portion of the opening operation of the exemplar circuit breaker, the generating comprising analysis of the exemplar travel curve data of the moveable contact with respect to the fixed contact over the at least a portion of the opening operation of the exemplar circuit breaker by the trained sequence to sequence model; and
- outputting, by an output unit, the exemplar temporal vibration data over the at least a portion of the opening operation of the exemplar circuit breaker.

In an example, the at least a portion of the opening operation of the exemplar circuit breaker is the same as the at least a portion of the plurality of the reference opening operations of the at least one reference circuit breaker.

In an example, the plurality of travel curve data of the moveable contact with respect to the fixed contact of the plurality of reference opening operations of the at least one reference circuit breaker comprises displacement data as a function of time of the moveable contact with respect to the fixed contact, and the travel curve data of the moveable contact with respect to the fixed contact of the opening operation of the exemplar circuit breaker comprises displacement data as a function of time of the moveable contact with respect to the fixed contact

In an example, the at least a portion of the opening operation of the exemplar circuit breaker comprised initiation of the opening operation and/or latch release, and wherein the at least a portion of the plurality of the reference opening operations of the at least one reference circuit breaker comprised initiation of the opening operation and/or latch release.

In an example, the at least a portion of the opening operation of the exemplar circuit breaker comprised separation of the moveable contact from the fixed contact and/or stop of movement of the moveable contact, and wherein the at least a portion of the plurality of the reference opening operations of the at least one reference circuit breaker comprised separation of the moveable contact from the fixed contact and/or stop of movement of the moveable contact.

In an example, at least some of the plurality of travel curve data of a moveable contact with respect to a fixed contact over at least a portion of a plurality of reference opening operations of at least one reference circuit breaker was synthetically generated.

The circuit breaker monitoring systems, circuit breaker monitoring methods, circuit breaker vibrations data generators, circuit breaker vibrations data generation methods are now described in further specific detail, where reference is made to Figs. 3-5.

Thus, the inventors realized that they could apply methods of artificial intelligence (Al) to transform travel curve data of a circuit breaker from the laboratory and other prior setups into vibration data that corresponds to the same failure mode or healthy state. This enables the creation of synthetic training data. The inventors also realized that this transformation could be in effect be utilized within a trained machine learning algorithm, such as a neural network that was trained on travel curve data and vibration data, which when presented with vibration data of a circuit breaker in the field in effect is able to determine a health state of the circuit breaker - as if the travel curve has been acquired, but rather simpler to acquire vibration data has been utilized.

The inventors started from the position that the travel curve sensor data is a good indicator of faults, but is difficult to implement in the field. Thus, the new technique was developed to address this.

Also, the inventors realized that there is a relatively large amount of available large amount of laboratory travel curve data from endurance tests, with associated vibration data. However, for the training of models etc., it is preferable to utilize travel curve data and associated vibration data for circuit breakers operating correctly and with various deficiencies. Synthetic travel curve data can be generated through simulations, calculated for example using standard multibody and FE simulation approaches. However, the computation of the impact-induced vibrations requires more sophisticated methods considering e.g., the wave propagation of all mechanism parts connected via joints and bearings. Thus, the new technique also enabled synthetic vibration data to be more easily generated, that could then be utilized for example is system models.

Thus, the new technique enables available real and synthetic travel curve data to be used to train machine learning models that will not receive the same type of sensor data but receive data such as vibration data.

Fig. 3 shows a detailed example of the training and operation of an exemplar circuit breaker vibration data generator.

Here, different sensors (for example vibration) for example vibration sensors, that are different to the sensors used to obtain travel curve data are used to obtain data that is also used with the existing corpus of travel curve data to augment the training data set. A sequence-to-sequence model (termed Model T in Fig. 3) is trained and that then can transform travel curve data into corresponding data from the other sensors (vibration data).

Based on existing data where both travel curves and vibration data (or other sensor data) was collected from experiments, a sequence to sequence model is trained. When exposed to new, unseen travel curve data, the model is able to generate corresponding data of the other sensor. The model (Model T) can be trained unsupervised. However, data from both healthy and faulty cases is utilized in the training data. The accuracy of this method is evaluated using some accuracy metric, such as the mean squared error or the Manhattan distance, across all samples used in training and testing.

The output of Model T, the other sensor data (OSD), can have many forms. It can be raw vibration data, but it also be the signal envelope or its frequency domain. It could be specific features that of this data like peaks, changepoints or values in certain frequencies. Other sensor signals are possible as well.

This is what is meant by vibration data and the other sensor data.

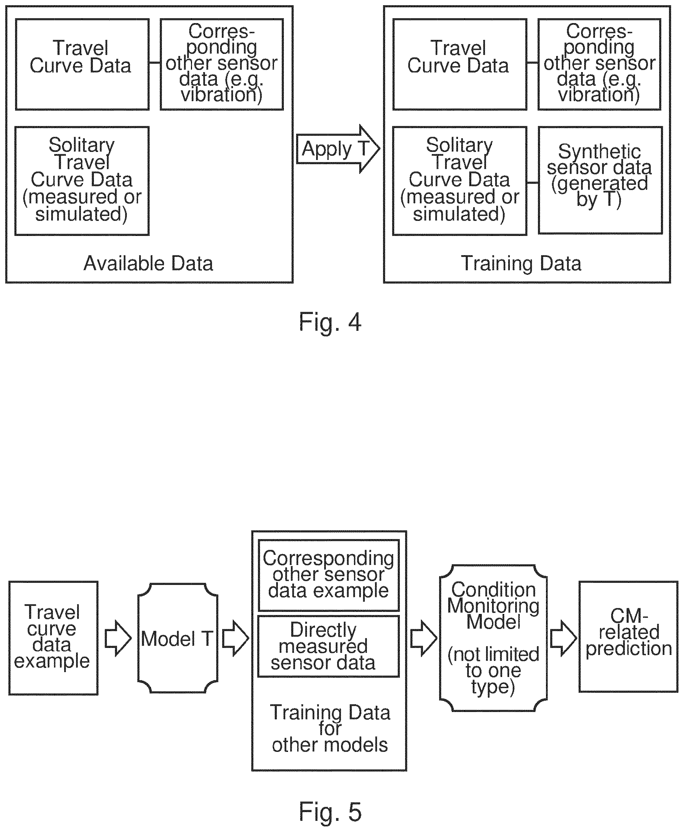

Fig. 4 shows a detailed example of the operation of an exemplar circuit breaker vibration data generator.

Then, as shown in Fig. 4 when the model T is trained, it is used to augment the training data for the ML algorithm (see Fig. 4). In this process, existing travel curve data (and for some applications labeled as healthy/faulty) can be used to generate additional training data. Additionally, one can use simulated travel curves (from standard multibody, FE simulation approaches or other techniques) to get other sensor data that would not be produced in a realistic fashion by a simulation. As a result, the training data available consists of actually measured sensor data and examples that are generated synthetically by model T.

Also, an ML algorithm can be trained on travel curve data and vibration data, as defined above, that when presented with vibration data in the field from a circuit breaker can determine the operational health status of the circuit breaker, such as operating correctly of has a fault, and even determine the type of fault from this vibration data. The vibration data is more easily sensed from the circuit breaker, certainly more simply than the data needed to determine the travel curve data, but the diagnostic capability is as good as if travel curve data had been acquired and utilized to assess the health of the circuit breaker.

Fig. 5 shows a representation of the utilization of generated data.

As described above, the new technique can be used for different scenarios that most likely follow the pattern shown in Fig. 5. Model T is used to ensure that the maximum amount of training data is available by "converting" available travel curve data into the data of the sensor type used. The new augmented training data set can be used for a series of models including but not limited to:
- Classifiers that detect healthy and faulty states
- Anomaly detection algorithms
- Prediction of future states
- Identification and localization of the failure mode
- Prognostics, e.g., via remaining useful life estimation.

In another exemplary embodiment, a computer program or computer program element is provided that is characterized by being configured to execute the method steps of the method according to one of the preceding embodiments, on an appropriate processor or system.

The computer program element might therefore be stored on a computer unit, which might also be part of an embodiment. This computing unit may be configured to perform or induce performing of the steps of the method described above. Moreover, it may be configured to operate the components of the above described system. The computing unit can be configured to operate automatically and/or to execute the orders of a user. A computer program may be loaded into a working memory of a data processor. The data processor may thus be equipped to carry out the method according to one of the preceding embodiments.

This exemplary embodiment of the invention covers both, a computer program that right from the beginning uses the invention and computer program that by means of an update turns an existing program into a program that uses the invention.

Further on, the computer program element might be able to provide all necessary steps to fulfill the procedure of an exemplary embodiment of the method as described above.

According to a further exemplary embodiment of the present invention, a computer readable medium, such as a CD-ROM, USB stick or the like, is presented wherein the computer readable medium has a computer program element stored on it which computer program element is described by the preceding section.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

## Claims

1. A circuit breaker monitoring system, comprising:
- a vibration sensor (10);
- a processing unit (20); and
- an output unit (30);
wherein the vibration sensor is configured to be mounted to a circuit breaker;
wherein the vibration sensor is configured to acquire temporal vibration data over at least a portion of a closing operation of the circuit breaker, wherein the at least a portion of the closing operation comprises: movement of a moveable contact towards a fixed contact;
wherein the vibration sensor is configured to provide the temporal vibration data to the processing unit;
wherein the processing unit is configured to determine an indication of operational functionality of the circuit breaker, wherein the determination comprising analysis of the temporal vibration data by a machine learning algorithm, and wherein the machine learning algorithm was trained on a plurality of travel curve data of a moveable contact with respect to a fixed contact over at least a portion of a plurality of reference closing operations of at least one reference circuit breaker and was trained on a plurality of temporal vibration data over the at least a portion of the plurality of the reference closing operations of the at least one reference circuit breaker, wherein the at least a portion of the reference closing operations comprised: movement of a moveable contact towards a fixed contact; and
wherein the output unit is configured to output information relating to the indication of operational functionality of the circuit breaker.

2. System according to claim 1, wherein the at least a portion of the closing operation of the circuit breaker is the same as the at least a portion of the plurality of the reference closing operations of the at least one reference circuit breaker.

3. System according to any of claims 1-2, wherein the plurality of travel curve data of the moveable contact with respect to the fixed contact of the plurality of reference closing operations of the at least one reference circuit breaker comprises displacement data as a function of time of the moveable contact with respect to the fixed contact.

4. System according to any of claims 1-3, wherein the at least a portion of the closing operation of the circuit breaker comprises initiation of the closing operation and/or latch release, and wherein the at least a portion of the plurality of the reference closing operations of the at least one reference circuit breaker comprised initiation of the closing operation and/or latch release.

5. System according to any of claims 1-4, wherein the at least a portion of the closing operation of the circuit breaker comprises contact touch of the moveable contact with the fixed contact and/or stop of movement of the moveable contact, and wherein the at least a portion of the plurality of the reference closing operations of the at least one reference circuit breaker comprised contact touch of the moveable contact with the fixed contact and/or stop of movement of the moveable contact.

6. A circuit breaker monitoring system, comprising:
- a vibration sensor (10);
- a processing unit (20); and
- an output unit (30);
wherein the vibration sensor is configured to be mounted to a circuit breaker;
wherein the vibration sensor is configured to acquire temporal vibration data over at least a portion of an opening operation of the circuit breaker, wherein the at least a portion of the opening operation comprises: movement of a moveable contact away from a fixed contact;
wherein the vibration sensor is configured to provide the temporal vibration data to the processing unit;
wherein the processing unit is configured to determine an indication of operational functionality of the circuit breaker, wherein the determination comprising analysis of the temporal vibration data by a machine learning algorithm, and wherein the machine learning algorithm was trained on a plurality of travel curve data of a moveable contact with respect to a fixed contact over at least a portion of a plurality of reference opening operations of at least one reference circuit breaker and was trained on a plurality of temporal vibration data over at least a portion of the plurality of the reference opening operations of the at least one reference circuit breaker, wherein the at least a portion of the reference opening operations comprised: movement of a moveable contact away from a fixed contact; and
wherein the output unit is configured to output information relating to the indication of operational functionality of the circuit breaker.

7. System according to claim 6, wherein the at least a portion of the opening operation of the circuit breaker comprises initiation of the opening operation and/or latch release, and wherein the at least a portion of the plurality of the reference opening operations of the at least one reference circuit breaker comprised initiation of the opening operation and/or latch release.

8. System according to any of claims 6-7, wherein the at least a portion of the opening operation of the circuit breaker comprises separation of the moveable contact from the fixed contact and/or stop of movement of the moveable contact, and wherein the at least a portion of the plurality of the reference opening operations of the at least one reference circuit breaker comprised separation of the moveable contact from the fixed contact and/or stop of movement of the moveable contact.

9. A circuit breaker monitoring method, comprising:
- acquiring, by a vibration sensor mounted to a circuit breaker, temporal vibration data over at least a portion of a closing operation of the circuit breaker, wherein the at least a portion of the closing operation comprises: movement of a moveable contact towards a fixed contact;
- providing, by the vibration sensor, the temporal vibration data to a processing unit;
- determining, by the processing unit, an indication of operational functionality of the circuit breaker, wherein the determining comprising analyzing the temporal vibration data by a machine learning algorithm, and wherein the machine learning algorithm was trained on a plurality of travel curve data of a moveable contact with respect to a fixed contact over at least a portion of a plurality of reference closing operations of at least one reference circuit breaker and was trained on a plurality of temporal vibration data over the at least a portion of the plurality of the reference closing operations of the at least one reference circuit breaker, wherein the at least a portion of the reference closing operations comprised: movement of a moveable contact towards a fixed contact; and
- outputting, by an output unit, information relating to the indication of operational functionality of the circuit breaker.

10. A circuit breaker monitoring method, comprising:
- acquiring, by a vibration sensor mounted to a circuit breaker, temporal vibration data over at least a portion of an opening operation of the circuit breaker, wherein the at least a portion of the opening operation comprises: movement of a moveable contact away from a fixed contact;
- providing, by the vibration sensor, the temporal vibration data to a processing unit;
- determining, by the processing unit, an indication of operational functionality of the circuit breaker, wherein the determining comprising analyzing the temporal vibration data by a machine learning algorithm, and wherein the machine learning algorithm was trained on a plurality of travel curve data of a moveable contact with respect to a fixed contact over at least a portion of a plurality of reference opening operations of at least one reference circuit breaker and was trained on a plurality of temporal vibration data over at least a portion of the plurality of the reference opening operations of the at least one reference circuit breaker, wherein the at least a portion of the reference opening operations comprised: movement of a moveable contact away from a fixed contact; and
- wherein the output unit is configured to output information relating to the indication of operational functionality of the circuit breaker.

11. A circuit breaker vibration data generator, comprising:
- an input unit (60);
- a processing unit (70);
- an output unit (80);
wherein the input unit is configured to provide the processing unit with a plurality of travel curve data of a moveable contact with respect to a fixed contact over at least a portion of a plurality of reference closing operations of at least one reference circuit breaker and a plurality of temporal vibration data over the at least a portion of the plurality of the reference closing operations of the at least one reference circuit breaker, wherein the at least a portion of the reference closing operations comprised: movement of a moveable contact towards a fixed contact, and wherein the plurality of temporal vibration data was acquired by at least one vibration sensor mounted to the at least one reference circuit breaker;
wherein the processing unit is configured to train a sequence to sequence model comprising utilization of the plurality of travel curve data of the moveable contact with respect to the fixed contact over the at least a portion of the plurality of reference closing operations of the at least one reference circuit breaker and the plurality of temporal vibration data over the at least a portion of the plurality of the reference closing operations of the at least one reference circuit breaker;
wherein the input unit is configured to provide the processing unit with exemplar travel curve data of a moveable contact with respect to a fixed contact over at least a portion of a closing operation of an exemplar circuit breaker, wherein the at least a portion of the closing operation comprised: movement of a moveable contact towards a fixed contact;
wherein the processing unit is configured to generate exemplar temporal vibration data over the at least a portion of the closing operation of the exemplar circuit breaker, the generation comprising analysis of the exemplar travel curve data of the moveable contact with respect to the fixed contact over the at least a portion of the closing operation of the exemplar circuit breaker by the trained sequence to sequence model; and
wherein the output unit is configured to output the exemplar temporal vibration data over the at least a portion of the closing operation of the exemplar circuit breaker.

12. A circuit breaker vibration data generator, comprising:
- an input unit (60);
- a processing unit (70);
- an output unit (80);
wherein the input unit is configured to provide the processing unit with a plurality of travel curve data of a moveable contact with respect to a fixed contact over at least a portion of a plurality of reference opening operations of at least one reference circuit breaker and a plurality of temporal vibration data over the at least a portion of the plurality of the reference opening operations of the at least one reference circuit breaker, wherein the at least a portion of the reference opening operations comprised: movement of a moveable contact away from a fixed contact, and wherein the plurality of temporal vibration data was acquired by at least one vibration sensor mounted to the at least one reference circuit breaker;
wherein the processing unit is configured to train a sequence to sequence model comprising utilization of the plurality of travel curve data of the moveable contact with respect to the fixed contact over the at least a portion of the plurality of reference opening operations of the at least one reference circuit breaker and the plurality of temporal vibration data over the at least a portion of the plurality of the reference opening operations of the at least one reference circuit breaker;
wherein the input unit is configured to provide the processing unit with exemplar travel curve data of a moveable contact with respect to a fixed contact over at least a portion of an opening operation of an exemplar circuit breaker, wherein the at least a portion of the opening operation comprised: movement of a moveable contact away from a fixed contact;
wherein the processing unit is configured to generate exemplar temporal vibration data over the at least a portion of the opening operation of the exemplar circuit breaker, the generation comprising analysis of the exemplar travel curve data of the moveable contact with respect to the fixed contact over the at least a portion of the opening operation of the exemplar circuit breaker by the trained sequence to sequence model; and
wherein the output unit is configured to output the exemplar temporal vibration data over the at least a portion of the opening operation of the exemplar circuit breaker.

13. A circuit breaker vibration data generation method, comprising:
- providing, by an input unit, a processing unit with a plurality of travel curve data of a moveable contact with respect to a fixed contact over at least a portion of a plurality of reference closing operations of at least one reference circuit breaker and a plurality of temporal vibration data over the at least a portion of the plurality of the reference closing operations of the at least one reference circuit breaker, wherein the at least a portion of the reference closing operations comprised: movement of a moveable contact towards a fixed contact, and wherein the plurality of temporal vibration data was acquired by at least one vibration sensor mounted to the at least one reference circuit breaker;
- training, by the processing unit, a sequence to sequence model comprising utilizing the plurality of travel curve data of the moveable contact with respect to the fixed contact over the at least a portion of the plurality of reference closing operations of the at least one reference circuit breaker and the plurality of temporal vibration data over the at least a portion of the plurality of the reference closing operations of the at least one reference circuit breaker;
- providing, by the input unit, the processing unit with exemplar travel curve data of a moveable contact with respect to a fixed contact over at least a portion of a closing operation of an exemplar circuit breaker, wherein the at least a portion of the closing operation comprised: movement of a moveable contact towards a fixed contact;
- generating, by the processing unit, exemplar temporal vibration data over the at least a portion of the closing operation of the exemplar circuit breaker, the generating comprising analyzing the exemplar travel curve data of the moveable contact with respect to the fixed contact over the at least a portion of the closing operation of the exemplar circuit breaker by the trained sequence to sequence model; and
- outputting, by an output unit, the exemplar temporal vibration data over the at least a portion of the closing operation of the exemplar circuit breaker.

14. A circuit breaker vibration data generation method, comprising:
- providing, by an input unit, a processing unit with a plurality of travel curve data of a moveable contact with respect to a fixed contact over at least a portion of a plurality of reference opening operations of at least one reference circuit breaker and a plurality of temporal vibration data over the at least a portion of the plurality of the reference opening operations of the at least one reference circuit breaker, wherein the at least a portion of the reference opening operations comprised: movement of a moveable contact away from a fixed contact, and wherein the plurality of temporal vibration data was acquired by at least one vibration sensor mounted to the at least one reference circuit breaker;
- training, by the processing unit, a sequence to sequence model comprising utilizing the plurality of travel curve data of the moveable contact with respect to the fixed contact over the at least a portion of the plurality of reference opening operations of the at least one reference circuit breaker and the plurality of temporal vibration data over the at least a portion of the plurality of the reference opening operations of the at least one reference circuit breaker;
- providing, by the input unit, the processing unit with exemplar travel curve data of a moveable contact with respect to a fixed contact over at least a portion of an opening operation of an exemplar circuit breaker, wherein the at least a portion of the opening operation comprised: movement of a moveable contact away from a fixed contact;
- generating, by the processing unit, exemplar temporal vibration data over the at least a portion of the opening operation of the exemplar circuit breaker, the generating comprising analysis of the exemplar travel curve data of the moveable contact with respect to the fixed contact over the at least a portion of the opening operation of the exemplar circuit breaker by the trained sequence to sequence model; and
- outputting, by an output unit, the exemplar temporal vibration data over the at least a portion of the opening operation of the exemplar circuit breaker.

15. A computer program element for controlling a system which when executed by a processor is configured to carry out the method of any of claims 9, 10, 13, 14 .
